# EUROPÄISCHE PATENTANMELDUNG

(11) **EP 2 249 135 A1**
(43) Veröffentlichungstag der Anmeldung: **10.11.2010**
(21) Anmeldenummer: 09159745.0
(22) Anmeldetag: 08.05.2009
(51) Int. Cl.: G01G 3/14, G01G 3/142, G01L 1/22, H03M 1/10, H03H 7/24

(54) **Widerstandsnetzwerk, Kraftmessvorrichtung und Verfahren zur justierung der Kraftmessvorrichtung**

(71) Anmelder: Mettler-Toledo AG, 8606 Greifensee (CH)
(72) Erfinder: Selig, Klaus Peter, 8606, Greifensee (CH); Bäumel, Helmut, 8606, Greifensee (CH)

(57) **Zusammenfassung**

Die Erfindung betrifft ein Widerstandsnetzwerk (50) für eine Kraftmessvorrichtung (1), insbesondere eine Waage, mit mindestens zwei elektrischen Teilwiderständen (R1, R2, R3, R4), welche abgestufte Widerstandwerte aufweisen, sodass jeweils eine unterschiedliche elektrische Verdrahtung der Teilwiderstände (R1, R2, R3, R4) einen unterschiedlichen Gesamt-Widerstandswert (R) des Widerstandsnetzwerks (50) ergibt. Dabei weist das Widerstandsnetzwerk (50) zur Verdrahtung der Teilwiderstände (R1, R2, R3, R4) ein codierendes Schaltelement (SW) auf, sodass verschiedenen Schaltstellungen (POS) des Schaltelements (SW) verschiedene Verdrahtungen der Teilwiderstände (R1, R2, R3, R4) zuordenbar sind und die Anzahl der Teilwiderstände (R1, R2, R3, R4) geringer ist als die Anzahl der möglichen Schaltstellungen (POS).

## Beschreibung

Die vorliegende Erfindung betrifft ein Widerstandsnetzwerk für die Justierung einer Kraftmessvorrichtung, insbesondere einer Waage, eine entsprechende Kraftmessvorrichtung und ein Verfahren zur Justierung der Kraftmessvorrichtung.

Üblicherweise umfasst eine Kraftmessvorrichtung eine Kraftaufnahme, eine Kraftübertragung, eine Kraftmesszelle und eine Vorrichtung zur Verarbeitung der Messsignale. Dabei wird eine zu messende Kraft mittels der Kraftaufnahme aufgenommen, über die Kraftübertragung an die Kraftmesszelle weitergeleitet, wo sie als zugeführte Kraft auf die Kraftmesszelle wirkt. Insbesondere ergibt sich bei einer Waage die zu messende Kraft durch die Gewichtskraft des Wägeguts, welche auf die Kraftaufnahme in Form einer Waagschale einwirkt und welche über ein Gestänge auf die Kraftmesszelle, die sogenannte Wägezelle, übertragen wird.

Die Kraftmesszelle ist ein mechanisch-elektrischer Wandler, der die zugeführte Kraft in ein elektrisches Messsignal wandelt. Dabei korrespondiert das Messsignal zu der Kraft, welche auf die Kraftmessvorrichtung einwirkt. Das Messsignal wird von der Kraftmesszelle an eine Signalverarbeitungseinheit weitergeleitet, dort verarbeitet und ausgewertet. Die Ergebnisse der Verarbeitung werden als Ausgabesignal an eine Anzeigeeinheit oder an eine weitere Verarbeitungseinheit, beispielsweise an einen Leitrechner oder an eine Anlagensteuerung, weitergeleitet.

Aus dem Stand der Technik ist bekannt, dass Kraftmesszellen bezüglich individuellen Abweichungen korrigiert werden müssen, um Fertigungstoleranzen oder unterschiedliche Materialeigenschaften auszugleichen. Beispielsweise offenbart EP 0101247 A2 eine Waage mit mehreren Dehnmessstreifen, bei welcher die unterschiedliche Empfindlichkeit der verschiedenen Dehnmessstreifen zu sogenannten Eckenlastfehlern führt. Diese Eckenlastfehler werden mit Abgleichwiderständen kompensiert, die in Serie oder parallel zu den Dehnmessstreifen geschaltet werden. Bei der Bestimmung der Abgleichwiderstände sind verschiedene Faktoren wie das Temperaturverhalten oder die unterschiedliche Alterung der Dehnmessstreifen zu berücksichtigen. Daher werden in der Regel für diese Abgleichwiderstände nicht feste Widerstände sondern verstellbare Widerstände verwendet, welche mittels Justierung auf die optimalen Werte eingestellt werden können.

Die Anforderungen an die Abgleichwiderstände sind relativ hoch, sowohl bezüglich Langzeitstabilität als auch bezüglich Temperaturverhalten. Daher sind kontinuierlich verstellbare Widerstände, sogenannte Trim-Potentiometer, mit einem auf einer Widerstandsbahn verschiebbaren Abgriff weniger geeignet. Zudem werden technische Hilfsmittel wie ein Widerstandsmessgerät benötigt um den aktuellen Widerstandswert zu bestimmen und reproduzierbar einzustellen.

Zur Vermeidung dieser Probleme werden in der Kraftmesstechnologie meist Widerstandsnetzwerke eingesetzt, welche feste elektrische Widerstände, sogenannte Teilwiderstände, aufweisen. Durch unterschiedliche elektrische Verdrahtungen dieser Teilwiderstände ergeben sich dann unterschiedliche Gesamt-Widerstandswerte des Widerstandsnetzwerks.

Werden jedoch hohe Anforderungen an die Messgenauigkeit gestellt, so muss der Gesamt-Widerstandswert sehr genau einstellbar sein. Das erfordert sehr feine Abstufungen der möglichen Widerstandswerte und damit eine grosse Anzahl von Teilwiderständen. Zudem müssen die fein abgestuften Widerstandswerte genau und stabil eingehalten werden, sodass entsprechend teure Messwiderstände mit kleinen Toleranzen erforderlich sind.

Zur Vermeidung einer Vielzahl von einzelnen Teilwiderständen werden diese meist in geeigneter Weise zusammengeschaltet. Zum Beispiel offenbart US 4,556,115 eine Waage mit mehreren Wägezellen, deren Empfindlichkeit jeweils durch ein Widerstandsnetzwerk in Form eines sogenannten Leiternetzwerks justiert werden kann. Dieses Widerstandsnetzwerk ist aus Teilwiderständen aufgebaut, welche binär abgestufte Widerstandwerte aufweisen. In einem anfänglichen Zustand sind die Teilwiderstände durch Kurzschlüsse überbrückt und damit inaktiv. Zum Abgleich der Wägezelle, werden in einem ersten Schritt die erforderlichen Widerstandswerte des Widerstandsnetzwerk berechnet, in einem zweiten Schritt die benötigten Teilwiderstände bestimmt und diese dann in einem dritten Schritt aktiviert, indem bei den ausgewählten Teilwiderständen die zugehörigen Überbrückungen entfernt werden. Somit ergibt eine unterschiedliche elektrische Verdrahtung der Teilwiderstände jeweils einen unterschiedlichen Gesamt-Widerstandswert des Widerstandsnetzwerks.

Nachteilig bei der genannten Methode ist, dass die Auswahl und Aktivierung der benötigten Teilwiderstände fehlerträchtig sein kann, insbesondere bei einer grösseren Anzahl von Teilwiderständen. So können beispielsweise bei einer Verdrahtung, bei welcher der erste, dritte und sechste Teilwiderstand zu aktivieren und der zweite, vierte, fünfte, siebte und achte Teilwiderstand zu überbrücken sind, leicht Vertauschungen entstehen. Für eine präzise Justierung werden allerdings viele Abstufungen und damit eine hohe Anzahl von möglichen Verdrahtungen benötigt.

Der vorliegenden Erfindung liegt daher die Aufgabe zugrunde, ein Widerstandsnetzwerk für eine Kraftmessvorrichtung, insbesondere eine Waage, anzugeben, mit welchem ein einfacher und kostengünstiger Aufbau und eine effiziente Justierung der Kraftmessvorrichtung erreicht werden kann, bei gleichzeitiger Erfüllung von hohen Anforderungen bezüglich Messgenauigkeit und Stabilität. Insbesondere soll der Widerstandswert des Widerstandsnetzwerks präzis, reproduzierbar und zuverlässig einstellbar sein. Ausserdem soll eine geeignete Verschaltungsbox, eine geeignete Kraftmessvorrichtung und ein entsprechendes Verfahren zum Justieren der Kraftmessvorrichtung angegeben werden.

Diese Aufgabe wird mit einem Widerstandsnetzwerk und einem Verfahren gelöst, welche die in den unabhängigen Ansprüchen angegebenen Merkmale aufweisen. Vorteilhafte Ausgestaltungen der Erfindung sind in den weiteren, abhängigen Ansprüchen angegeben.

Die Erfindung betrifft ein Widerstandsnetzwerk für eine Kraftmessvorrichtung, insbesondere eine Waage, mit mindestens zwei elektrischen Teilwiderständen, welche abgestufte Widerstandwerte aufweisen, sodass jeweils eine unterschiedliche elektrische Verdrahtung der Teilwiderstände einen unterschiedlichen Gesamt-Widerstandswert des Widerstandsnetzwerks ergibt. Dabei weist das Widerstandsnetzwerk zur Verdrahtung der Teilwiderstände ein codierendes Schaltelement auf, sodass verschiedenen Schaltstellungen des Schaltelements verschiedene Verdrahtungen der Teilwiderstände zuordenbar sind und die Anzahl der Teilwiderstände geringer ist als die Anzahl der möglichen Schaltstellungen. Durch diese Codierung kann einerseits die Anzahl der benötigten Teilwiderstände reduziert werden und andererseits sind Bedienungsfehler, Fehlmanipulationen oder/und Irrtümer bei der Beschaltung der Teilwiderstände weitgehend ausgeschlossen. Somit wird auch bei hohen Anforderungen bezüglich Messgenauigkeit und Stabilität eine zuverlässige und reproduzierbare Justierung der Kraftmessvorrichtung gewährleistet.

Codierende Schaltelemente selbst sind aus dem Stand der Technik bekannt. Diese Schaltelemente umfassen mehrere Schaltkontakte, welche je nach Schaltstellung des Schaltelements durch geschlossene oder getrennte elektrische Verbindungen verdrahtet beziehungsweise beschaltet sind. Dabei ist im Allgemeinen unter einer Codierung eine vorgegebene Zuordnung jeder der möglichen Schaltstellungen des Schaltelements auf eine eindeutige Beschaltung der Teilwiderstände zu verstehen.

Grundsätzlich kann eine Codierung auf beliebige Weise festgelegt werden. Erfindungsgemäss soll jedoch eine Codierung verwendet werden, welche zu einer reduzierten Anzahl von Teilwiderständen führt. Das ergibt den Vorteil einer mehrfachen Verwendung der vorhandenen Teilwiderstände bei verschiedenen Schaltstellungen und somit einen einfachen und kostengünstigen Aufbau des Widerstandsnetzwerks. Zum Beispiel können bei einem Widerstandsnetzwerk mit einem binär codierenden Schaltelement und vier Teilwiderständen 16 verschiedenen Schaltstellungen und damit 16 verschiedene Gesamt-Widerstandswerte eingestellt werden. Im Gegensatz dazu ist eine Kombination eines einfachen Umschalters mit direkt angeschlossenen Teilwiderständen nicht als codierendes Schaltelement anzusehen, da trotz der eindeutigen Zuordnung keine Reduktion der Anzahl der Teilwiderstände gegeben ist.

Binär codierende Schaltelemente werden in der Digitaltechnik häufig zur Festlegung von elektrischen Spannungen, sogenannten Pegelzuständen, verwendet. Dazu werden diese Schaltelemente mit den hochohmigen Eingängen digitaler Bausteine verbunden und die Spannungen an diesen Eingängen durch die Schaltstellung des Schaltelements definiert. Beispielsweise kann bei einem Mikroprozessor ein binärer Zahlenwert "1010" vorgegeben werden, indem an vier Eingängen des Mikroprozessors jeweils die Spannung +5 Volt, 0 Volt, +5 Volt und 0 Volt angelegt wird. Dabei können die Spannungen innerhalb eines weiten Bereichs abweichen, also typischerweise einem Bereich von ca. 20%, ohne dass es zu Fehlinterpretationen der Pegelzustände kommt. Somit ergibt sich ein sehr robustes Verhalten, insbesondere gegenüber äusseren Störungen und Fertigungstoleranzen. Codierende Schaltelemente sind frei am Markt erhältlich, zum Beispiel als codierende Drehschalter, welche über eine Schaltungsplatine mit den digitalen Bausteinen verbunden werden.

Gemäss der Erfindung wird jedoch das codierende Schaltelement nicht zur Vorgabe von Pegelzuständen, sondern zur Veränderung von Widerstandsnetzwerken in Kraftmessvorrichtungen einsetzt. Überraschenderweise hat sich gezeigt, dass das codierende Schaltelement der Digitaltechnik auch in einer analogen, niederohmigen Messschaltung einer Kraftmesszelle vorteilhaft eingesetzt werden kann. Analoge Kraftmesssignale sind sehr störempfindlich und erfordern, insbesondere bei hohen Genauigkeitsanforderungen, eine sehr präzise Justierung. Digitale Signale hingegen sind robust und können auf einfache Weise mit günstigen Komponenten, insbesondere mit codierenden Schaltelementen, verarbeitet werden. Daher werden in der Regel keine Bauteile der Digitaltechnik für analoge Messsignale eingesetzt.

Die erfindungsgemässe Lösung ist auch deshalb unerwartet, weil in der Regel bei einem Wechsel der Schaltstellung durch die Codierung unerwünschte Sprünge in der Beschaltung der Teilwiderstände entstehen. Beispielsweise kann eine ein-schrittige Änderung der Schaltstellung, dual darstellbar durch einen Wechsel von "0111" auf "1000", zu einer völlig anderen Beschaltung führen, nämlich zu einem Abschalten es zweiten, dritten und vierten Teilwiderstands und einem Zuschalten des ersten Teilwiderstands. Ein derartig sprunghaftes Verhalten scheint für die Justierung von Kraftmessvorrichtungen nicht geeignet, da zur Justierung von Kraftmessvorrichtungen möglichst kontinuierliche und gleichmässige Veränderungen des Gesamt-Widerstandswerts benötigt werden. Offenbar ergibt sich jedoch aus dem erfindungsgemässen Zusammenwirken des codierenden Schaltelements mit den abgestuften Widerstandswerten der Teilwiderstände eine unerwartet vorteilhafte Wirkung, nämlich gemäss der Ausgestaltung des Schaltelements eine weitgehend gleichmässige Änderung des Gesamt-Widerstandswerts bei einer entsprechenden Änderung der Schaltstellung des Schaltelements.

Codierende Schaltelemente bieten den Vorteil, dass die Codierung durch das Schaltelement selbst und nicht manuell, also beispielsweise nicht durch das Bedienpersonal und/oder das Servicepersonal, vorgenommen werden muss. Somit ist die Beschaltung der Teilwiderstände unmittelbar durch die eingebaute Codierung gegeben sodass Bedienungsfehler, Fehlmanipulationen oder/und Irrtümer weitgehend ausgeschlossen sind.

Ferner lässt sich der Gesamt-Widerstandswert des Widerstandsnetzwerks gezielt einstellen, da die Schaltstellung des Schaltelements den Gesamt-Widerstandswert eindeutig festlegt. Somit kann dieser zuverlässig und reproduzierbar eingestellt und/oder korrigiert werden.

Dadurch dass der Schalter die Kodierung übernimmt, kann auch ohne Verständnis von binären Systemen die Einstellung manuell erfolgen. Insbesondere kann auf externe Hilfsmittel wie Codiertabellen, Softwareunterstützung oder Rechner zur Umrechnung der Codierungen auf die Kombination der benötigten Teilwiderstände verzichtet werden. Somit ist mit dem codierenden Schaltelement eine besonders einfache, bequeme und zuverlässige Justierung möglich.

Ein weiterer Vorteil ergibt sich dadurch, dass der Zustand der aktuellen Einstellung aus der Schaltstellung des Schaltelements eindeutig ablesbar ist. Damit wird das Verfahren zur Eckenlasteinstellung erheblich vereinfacht.

Des Weiteren werden bei einer Änderung der Schaltstellung des Schaltelements die Beschaltungen aller Teilwiderstände praktisch gleichzeitig geändert. So kann beim Wechsel der Schaltstellungen das Auftreten von unerwünschten Übergangszuständen vermieden werden. Solche Übergangszustände können zu einem Gesamt-Widerstandswert des Widerstandsnetzwerks führen, welcher sehr ungünstig oder gar schädlich für die Kraftmesszelle und/oder die Kraftmessvorrichtung sein kann. Beispielsweise könnte bei einer manuellen Umstellung vom Zahlenwert "0111" auf "1000" (in dualer Darstellung) in einem ersten Schritt der Zahlenwert "1111" eingestellt werden, sodass in diesem Übergangszustand alle Teilwiderstände parallel geschaltet sind und somit der Gesamt-Widerstandswert einen Extremwert annnimmt. Solche Änderungen können die analoge Messschaltung einer Kraftmesszelle überlasten oder den Kalibriervorgang nachhaltig stören. Im Gegensatz dazu werden solche Übergangszustände durch das codierende Schaltelement völlig vermieden oder zumindest auf eine äusserst kurze Zeit, nämlich einen durch asynchrone Schaltkontakte bedingten Zeitversatz, begrenzt.

Grundsätzlich können die codierenden Schaltelemente auf vielfältige Weise ausgestaltet sein, beispielsweise als lineare Schalter oder als Drehschalter. Des Weiteren sind neben binär Codierungen der Schaltelemente auch trinäre Codierungen oder noch höherwertige Codierungen denkbar. Ferner sind auch komplementäre Schaltungen denkbar, bei denen sich die Veränderungen der Verdrahtungen in umgekehrter Weise zu den standardmässigen Schaltungen verhält. Vorteilhafte Ausführungen werden in den folgenden Abschnitten behandelt.

In einer ersten vorteilhaften Ausgestaltung der Erfindung weist das Schaltelement mindestens zwei veränderbar beschaltete Schaltkontakte auf, welche jeweils mit den Teilwiderständen verbunden sind, um diese gemäss der zugeordneten Schaltstellung, insbesondere in Serie oder parallel, zu beschalten. Dadurch kann die Verdrahtung der Teilwiderstände unmittelbar und übersichtlich durch die codierende Beschaltung der Schaltkontakte definiert werden.

Grundsätzlich können beliebige Beschaltungen der Teilwiderstände zusammen mit dem codierenden Schaltelement aufgebaut werden. Einige Beispiele von bevorzugten Konfigurationen sind in der Detailbeschreibung angegeben. Des Weiteren kann eine Serieschaltung der Teilwiderstände durch individuell schaltbare Kurzschlussbrücken realisiert werden, beispielsweise indem die Teilwiderstände jeweils durch eine schaltbare elektrische Überbrückung oder eine Kurzschlussbrücke aktivierbar beziehungsweise deaktivierbar sind, wobei die leitenden und nicht-leitenden Zustände dieser Brücken mittels des codierenden Schaltelements definiert werden. Vorzugsweise ist in einer weiteren vorteilhaften Ausgestaltung jeder der Teilwiderstände mittels des Schaltelements einzeln anwählbar oder es sind mindestens zwei der Teilwiderstände miteinander parallel und/oder in Serie verschaltbar.

In einer weiteren vorteilhaften Ausgestaltung der Erfindung ist den Schaltstellungen ein Zahlenwert zuordenbar, indem jedem Teilwiderstand jeweils eine Stelle des Zahlenwerts zugeordnet werden kann, wobei der Wert dieser Stelle zur Verdrahtung des Teilwiderstands korrespondiert. Dadurch kann die Schaltstellung auf übersichtliche Weise beschrieben, dargestellt und aufgebaut werden.

Die möglichen Verdrahtungen jedes einzelnen Teilwiderstands können durch entsprechende Symbole, Ziffern und/oder Buchstaben bezeichnet werden. Zum Beispiel kann ein aktiver Teilwiderstand durch eine "1" und ein inaktiver Teilwiderstand durch eine "0" repräsentiert werden. Bei höherstufigen Beschaltungen können entsprechend grössere Sätze von Symbolen, zum Beispiel "0", "1" und "2", zur Anwendung kommen. Dabei wird jedem der Teilwiderstände eine Stelle eines Zahlenwerts zugeordnet, zum Beispiel dem ersten Teilwiderstand die höchstwertige Stelle des Zahlenwerts, dem zweiten die nächst höherwertige Stelle und so weiter bis zum letzten Teilwiderstand, welchem die niedrigstwertige Stelle des Zahlenwerts zukommt.

In einer bevorzugten Ausgestaltung der Erfindung ist das Schaltelement derart ausgebildet, dass eine fortschreitende Veränderung der Schaltstellung eine fortschreitende Veränderung des Zahlenwerts bewirkt. Dadurch kann das Schaltelement auf einfache Weise aufgebaut werden, zum Beispiel mittels einfachen Codierscheiben.

Vorzugsweise ist das Schaltelement derart ausgebildet, dass jeder der möglichen Schaltstellungen des Schaltelements eine eindeutige Verdrahtung der Teilwiderstände zuordenbar ist und/oder dass das Verhältnis zwischen der Anzahl der möglichen Schaltstellungen und der Anzahl der Teilwiderstände maximal ist. Diese Codierung erlaubt bei einer gegeben Anzahl von Teilwiderständen eine maximale Ausnützung der Schaltkontakte und/oder eine maximal feine Abstufung und damit eine besonders genaue Justierung. Beispielsweise können bei einer binären Codierung mit 4 beschalten Teilwiderständen die maximale Zahl von 16 Schaltstellungen gewählt werden.

In einer weiter bevorzugten Ausgestaltung der Erfindung basiert das codierende Schaltelement auf einem Stellenwertsystem, insbesondere einem Dualsystem, einem BCD-System (Binary Coded Decimal) oder einem Hexadezimalsystem. Diese aus der Digitaltechnik bekannten Zahlensysteme erlauben eine besonders für Schaltelemente geeignete, übersichtliche Darstellung und einfache Verarbeitung und/oder Berechnung der Zahlenwerte. Beispielsweise kann ein Zahlenwert durch den Wert "1010" im Dualsystem, den Wert "A" im Hexadezimalsystem oder den Wert "10" im Dezimalsystem dargestellt werden.

In einer weiteren vorteilhaften Ausgestaltung der Erfindung ist das Schaltelement als DIP-Schalter ausgebildet. Dadurch können einfache, kompakte und kostengünstige Standard-Bauteile verwendet werden. Vorzugsweise ist der DIP-Schalter als Rotations-DIP-Schalter ausgebildet, sodass die verschiedenen Schaltstellungen durch einfache Drehung, ähnlich wie bei einem Trim-Potentiometer, auf besonders einfache und intuitive Weise eingestellt werden können. Rotations-DIP Schalter sind handelsüblich erhältlich, typischerweise mit 8, 10 und 16 Schaltstellungen.

In einer besonders vorteilhaften Ausgestaltung der Erfindung sind die Teilwiderstände derart dimensioniert, dass der Gesamt-Widerstandswert des Widerstandsnetzwerks eine von der Schaltstellung abhängige, weitgehend monoton steigende oder monoton abfallende Funktion ist. Dadurch kann der Gesamt-Widerstandswert auf besonders einfache und intuitive Weise justiert werden, da ein solches Verhalten den bekannten Trim-Potentiometern entspricht und somit allgemein bekannt ist. Beispielsweise können bei Schaltelementen mit 256 Schaltstellungen 8 Teilwiderstände mit binär gestuften Widerstandswerten von 1 kOhm, 2 kOhm, 4 kOhm, 8 kOhm, 16 kOhm, 32 kOhm, 64 kOhm und 128 kOhm eingesetzt werden.

Ohne die vorteilhafte Dimensionierung der Teilwiderstände können bei einer Veränderung der Schaltstellung des Schaltelements Rücksprünge im Verlauf des Gesamt-Widerstandswerts entstehen, welche sich aus der Codierung ergeben. Beispielsweise führt bei der Verwendung identischer Teilwiderstände ein einzelner Erhöhungsschritt von der Schaltstellung "0111" auf "1000" von der Parallelschaltung dreier Widerstände zur Durchgangsschaltung eines Widerstands und damit zu einem Anstieg des Gesamt-Widerstandswerts, während typischerweise ein Erhöhungsschritt eine gleiche oder höhere Anzahl von Parallelschaltungen und damit einem gleichen oder tieferem Gesamt-Widerstandswert ergibt. Durch eine geeignete Dimensionierung der Teilwiderstände werden jedoch solche Rücksprünge vermieden, so dass bei einem Erhöhungsschritt stets ein grösserer oder kleinerer Gesamt-Widerstandswert und damit stets ein kleineres oder grösseres Kraftmesssignal erzeugt wird. Dieses Verhalten ermöglicht eine besonders komfortable Justierung, da eine stetig monoton steigende oder monoton abfallende Funktion der menschlichen Natur auf intuitive Weise entspricht. Somit werden die Vorteile der Festwiderstände mit der einfachen Handhabung von kontinuierlich verstellbaren Widerständen, insbesondere von Trim-Potentiometern, kombiniert.

Vorzugsweise entsprechen die Widerstandswerte der Teilwiderstände in Wesentlichen einer standardmässigen Dimensionierung. Dadurch kann das Widerstandsnetzwerk mit Standard-Widerständen besonders schnell und kostengünstig aufgebaut werden. Beispielsweise können für die Teilwiderstände binär oder, abhängig von der Verfügbarkeit, annähernd binär gestufte Widerstandswerte aufweisen wie: 1 kOhm, 2 kOhm, 4.02 kOhm, 8.6 kOhm, 16 kOhm, 31.6 kOhm, 64.9 kOhm und 128 kOhm.

In einer weiteren, besonders vorteilhaften Ausgestaltung der Erfindung ist dem Widerstandsnetzwerk mindestens ein weiteres erfindungsgemässes Widerstandsnetzwerke zugeschaltet. Dabei bezieht sich der Begriff Schaltstellung stets auf die Stellung aller Schaltelemente. Dadurch kann mit einfachen Mitteln eine sehr genaue Justierung gemäss einer grossen Anzahl von Schaltstellungen erreicht werden. Vorzugsweise wird das weitere Widerstandsnetzwerk parallel oder in Serie zum ersten Widerstandsnetzwerk geschaltet.

In einer weiter bevorzugten Ausgestaltung dient eines der Widerstandsnetzwerke der Grobjustierung und eines der Widerstandsnetzwerke der Feinjustierung. Dadurch kann auf effiziente Weise eine sehr genaue Justierung erreicht werden. Beispielsweise kann durch das Parallelschalten von 2 Widerstandsnetzwerken mit je 16 Schaltstellungen und der Verwendung von 8 Teilwiderständen eine Feinabstufung von 256 Schritten erreicht werden. Das einspricht einer Genauigkeit von 0.04 %, sodass diese Widerstandsnetzwerke auch bei Kraftmessvorrichtung eingesetzt werden können, die den Anforderungen des Eichgesetzes entsprechen müssen.

Eine weitere Ausgestaltung der Erfindung betrifft eineVerschaltungsbox mit einem Innenraum, in welchem mindestens ein erfindungsgemässes Widerstandsnetzwerk angeordnet ist, wobei die Verschaltungsbox verschliessbar, insbesondere versiegelbar, ist. Dieses ergibt eine kompakte Einheit, welche auf vorteilhafte Weise in der Kraftmessvorrichtung angeordnet, ausgetauscht oder erneut justiert werden kann, ohne das weitere Umbauten erforderlich sind.

Eine weitere Ausgestaltung der Erfindung betrifft eine Kraftmessvorrichtung, insbesondere eine Waage, mit mindestens einer Kraftmesszelle, welche mindestens einen Messsensor aufweist, der mit mindestens einem erfindungsgemässen Widerstandsnetzwerk derart verbunden ist, dass das Widerstandsnetzwerk in Serie oder parallel zu dem mindestens einen Messsensor geschaltet ist. Je nach Anforderung kann die Art der Schaltung eine optimale Anpassung der Empfindlichkeit und/oder des Ausgangswiderstands der Kraftmesszelle erzielt werden.

In eine weiteren bevorzugte Ausgestaltung der Erfindung weist die Kraftmessvorrichtung mindestens zwei, insbesondere vier, gegebenenfalls über eine als Kraftaufnahme wirkende Messplatte gekoppelte, Kraftmesszellen auf, welche jeweils mit dem mindestens einen zugehörigen Widerstandsnetzwerk verbunden sind, sodass Unterschiede zwischen den einzelnen Kraftmesszellen durch eine Justierung ausgleichbar sind. Dadurch können auch kompliziert einzustellende Kraftmessvorrichtungen, sogenannte Mehrfach-Kraftmessvorrichtungen bequem und effiziente justiert werden.

Solche Mehrfach-Kraftmessvorrichtungen werden in der Wägetechnik oftmals eingesetzt, beispielsweise als Balkenwaagen oder Hängebahnwaagen mit zwei Kraftmesszellen oder als Bodenwaagen mit vier Kraftmesszellen. Dabei ist der Abgleich besonders kritisch, da je nach unterschiedlicher Empfindlichkeit und Positionierung der Last grössere Abweichungen bei den Messungen entstehen können.

Die Kraftmessvorrichtung oder Waage kann auf einem beliebigen Messprinzip basieren wie der Deformationsmessung mit Dehnmessstreifen oder der elektromagnetischen Kraftkompensation. Ferner kann das erfindungsgemässe Widerstandsnetzwerk für allgemeine und spezielle Justierungen und Abgleichvorgänge eingesetzt werden, beispielsweise zum Nulllast-Abgleich, zum Eckenlast-Abgleich, zur Kalibrierung oder zur Eichung der Kraftmessvorrichtung.

Schliesslich betrifft die Erfindung ein Verfahren zur Justierung einer Kraftmessvorrichtung mit einem erfindungsgemässen Widerstandsnetzwerk, wobei die Justierung durch eine schrittweise Veränderung der Schaltstellung durchgeführt wird. Dadurch kann der Gesamt-Widerstand auf definierte und reproduzierbare Weise eingestellt werden.

Ausserdem betrifft die Erfindung ein Justierverfahren einer Kraftmessvorrichtung mit mindestens zwei erfindungsgemässen Widerstandsnetzwerken, einem ersten zur Grobjustierung und einem zweiten zur Feinjustierung, wobei in einem ersten Schritt die Grobjustierung und in einem zweiten Schritt die Feinjustierung vorgenommen wird. Das ermöglicht eine effiziente und präzise Justierung des Gesamt-Widerstands des Widerstandsnetzwerks in einem grossen Bereich von Widerstandswerten.

Vorzugsweise haben die verwendeten Kraftmessvorrichtungen und/oder die erfindungsgemässen Widerstandsnetzwerke eine Auflösung von ungefähr 1/6000 oder 1/20000. Bei einem Widerstandsnetzwerk mit 256 Schaltstellungen ergibt sich dadurch eine Justiergenauigkeit von ca. 4,3 % beziehungsweise 1,3%.

Einzelheiten des erfindungsgemässen Widerstandsnetzwerks der Kraftmessvorrichtung und des erfindungsgemässen Verfahrens ergeben sich anhand der Beschreibung der in den Zeichnungen dargestellten Ausführungsbeispiele. Es zeigen:
- Fig. 1: eine Kraftmessvorrichtung 1 in beispielhafter Ausgestaltung in Form einer Waage, mit einer symbolisch dargestellten, einwirkenden Last L, einer Kraftmesszelle 10 mit vier Messsensoren 14a, 14b, 14c, 14d, einer Signalverarbeitungseinheit 60 und einer Anzeigeeinheit 70;
- Fig. 2: ein vereinfachtes Blockschema mit einem Widerstandsnetzwerk 50, dessen Gesamt-Widerstand R veränderbar ist, und mit einer Kraftmesszelle 10 gemäss Figur 1, deren Messsensoren 14a, 14b, 14c, 14d zu einer vierteiligen Brückenschaltung verbunden sind;
- Fig. 3a: eine vereinfachte schematische Darstellung eines codierenden Schaltelements SW, als Prinzipschaltung mit binär beschalteten Schaltkontakten T1, T2, T4, T8;
- Fig. 3b: eine beispielhafte Schalttabelle für das Schaltelement SW gemäss Figur 3a zur Definition der Beschaltung der Schaltkontakte pro Schaltstellung POS und einen zugehörigen Zahlenwert N;
- Fig. 4a: ein vereinfachtes Blockschema eines veränderbaren Widerstandsnetzwerks 50 gemäss Figur 2 mit dem codierenden Schaltelement SW gemäss Figur 3a und 3b und mit Teilwiderständen R1, R2, R3 und R4, welche durch das Schaltelement SW parallel schaltbar sind;
- Fig. 4b: ein Blockschema gemäss Figur 4, jedoch mit in Serie schaltbaren Teilwiderständen R1, R2, R3 und R4;
- Fig. 5: zwei vereinfachte Verläufe des Widerstandswerts R des Widerstandsnetzwerks 50 in Abhängigkeit der Schaltstellung POS bei zwei verschiedenen Prinzipien der Dimensionierung der Teilwiderstände;
- Fig. 6: ein weiteres Ausführungsbeispiel der Erfindung mit der Parallelschaltung eines ersten und eines zweiten Widerstandsnetzwerk 50 gemäss Figur 4a, das erste zur Grobjustierung Co und das zweite zur Feinjustierung Fi des Gesamt-Widerstandswerts R;
- Fig. 7: eine stark vereinfachte schematische Darstellung einer Bodenwaage 1 mit vier Kraftmesszellen 10, welche jeweils mit einem in einer Verschaltungsbox 51 befindlichen erfindungsgemässen Widerstandsnetzwerk 50 verbunden sind.

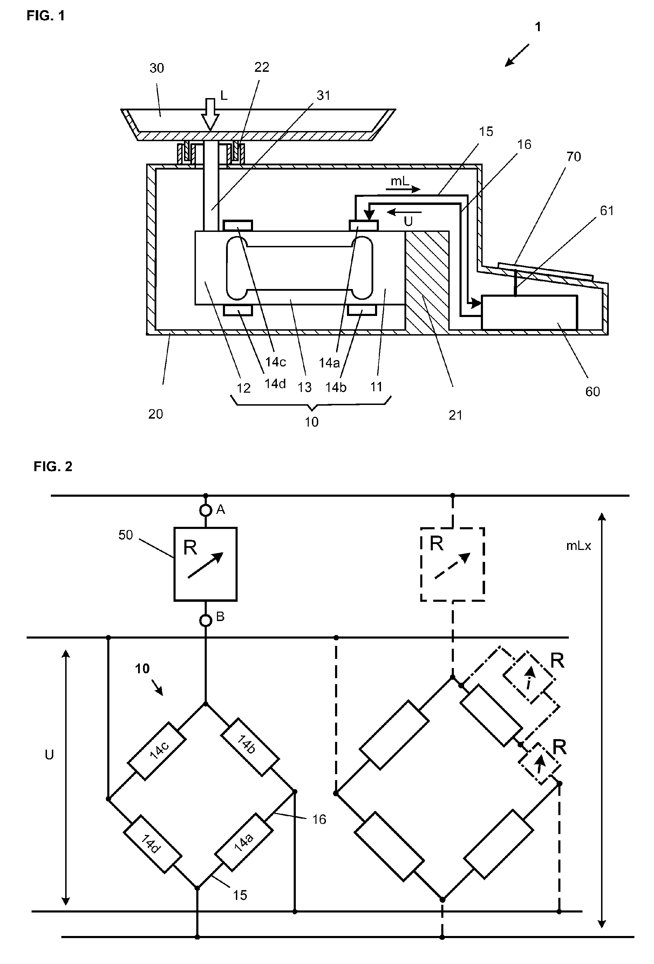

Figur 1 zeigt eine vereinfachte schematische Zeichnung einer Kraftmessvorrichtung 1 in beispielhafter Ausgestaltung als Waage im Schnitt, auf welche die Gewichtskraft des Wägeguts als Last L einwirkt und welche auf dem Prinzip der Deformationsmessung funktioniert. Es können aber auch andere Typen von Waagen verwendet werden, beispielsweise Waagen, welche auf dem Prinzip der Kraftkompensation basieren.

Die Waage weist ein Gehäuse 20 auf, in dessen Innenraum eine Kraftmesszelle 10 angeordnet ist. Die Kraftmesszelle 10 wiederum umfasst einen feststehenden Teil 11 und einen beweglichen Teil 12, welche durch einen Mittelteil 13 miteinander über Biegestellen verbunden sind. Ferner weist die Kraftmesszelle 10 vier Messsensoren 14a, 14b, 14c und 14d auf, welche die vertikale Verschiebung des beweglichen Teils 12 erfassen und diese vertikale Verschiebung in ein dazu korrespondierendes Kraftmesssignal mL umwandeln. Als Messsensoren 14 werden bevorzugt Dehnmessstreifen eingesetzt.

Die Kraftmesszelle 10 ist mit ihrem feststehenden Teil 11 über den gehäusefesten Support 21 mit dem Gehäuse 20 starr verbunden. Eine ausserhalb des Gehäuses 20 angeordnete Kraftaufnahme 30 in Form einer Waagschale ist über ein Gestänge 31 mit dem im Innenraum angeordneten beweglichen Teil 12 der Kraftmesszelle 10 verbunden. Das Gestänge 31 durchdringt das Gehäuse 20 berührungsfrei durch eine Gehäusedurchführung 22. Die Gehäusedurchführung 22 ist derart ausgebildet, dass ein Eindringen von Verunreinigungen möglichst vermieden oder zumindest stark reduziert wird.

Der erste Messsensor 14a ist über eine Messleitung 15 mit einer Signalverarbeitungseinheit 60 verbunden, um das vom Messsensor 14a erzeugte Kraftmesssignal mL an die Signalverarbeitungseinheit 60 weiterzuleiten. Ausserdem ist der Messsensor 14a über eine Versorgungsleitung 16 mit der Signalverarbeitungseinheit 60 verbunden, um die für den Betrieb des Messsensors 14a benötige Strom-/Spannungsversorgung U aufzunehmen.

Die Signalverarbeitungseinheit 60 ist über die weitere Verbindungsleitung 61 mit einer Anzeigeeinheit 70 verbunden, um die von der Verarbeitungseinheit 60 ermittelten Messwerte an die Anzeigeeinheit 70 zu übermittelt.

In gleicher Weise wie der erste Messsensor 14a sind auch die weiteren Messsensoren 14b, 14c und 14d mit der Signalverarbeitungseinheit 60 verbunden, um die jeweiligen Kraftmesssignale an diese weiterzuleiten und eine entsprechende Strom-/Spannungsversorgung U zu erhalten. Der Übersicht halber wurde auf die Darstellung dieser Verbindungsleitungen verzichtet.

Figur 2 zeigt ein vereinfachtes Blockschema mit einem Widerstandsnetzwerk 50, dessen Gesamt-Widerstand R veränderbar ist, und mit einer Kraftmesszellen 10 gemäss Figur 1. Bei dieser Brückenschaltung, einer sogenannten Wheatstoneschen Brücke, werden jeweils vier gleichartige Teile zusammengeschaltet, wobei jeder Teil der Brückenschaltung einen Messsensor 14a, 14b, 14c, 14d aufweist. Zwei gegenüberliegende Eckpunkt der Brückenschaltung sind mit der Strom-/Spannungsversorgung U verbunden, sodass dadurch die Speisung der Brückenschaltung erfolgt. Von den beiden anderen Eckpunkten ist der erste Eckpunkt über das veränderbare Widerstandsnetzwerk 50 mit einer ersten Signalleitung und der zweite Eckpunkt direkt mit einer zweiten Signalleitung verbunden. So ist der Messsensor 14a über die Messleitung 15 mit der zweiten Signalleitung und über die Versorgungsleitung 16 mit der Strom-/Spannungsversorgung U verbunden.

Das veränderbare Widerstandsnetzwerk 50 ist also einerseits über einen ersten Anschluss A mit einer ersten Signalleitung und andererseits über den zweiten Anschluss B mit einem Eckpunkt der Brückenschaltung verbunden. Die Anschlüsse A und B des Widerstandsnetzwerks 50 sind jedoch nicht als real existierende Anschlüsse zu sehen, sondern als Referenzpunkte für die Beschreibung der folgenden Figuren.

Das Widerstandsnetzwerk 50 ist verstellbar, sodass der Gesamt-Widerstandswert R des Widerstandsnetzwerks 50 durch manuelle Betätigung verändert werden kann. Anhand dieses Widerstandsnetzwerks 50 wird die Kraftmesszelle 10 justiert, um individuelle Abweichungen der Kraftmesszelle 10 wie zum Beispiel herstellungsbedingte Toleranzen der mechanischen Bauteile, insbesondere der Dehnmessstreifen, auszugleichen. Das justierte Messsignal mLx steht dann als Spannungsdifferenz zwischen der ersten und der zweiten Signalleitung zur weiteren Auswertung zur Verfügung.

In analoger Weise zu der Brückenschaltung der ersten Kraftmesszelle 10 kann auch die Brückenschaltung einer weiteren Kraftmesszellen parallel dazu geschaltet werden (gestrichelt gezeichnet). Somit ist diese weitere Brückenschaltung ebenfalls mit der Strom-/Spannungsversorgung U und mit den beiden Signalleitungen verbunden. Ebenso kann die weitere Brückenschaltung mittels eines weiteren erfindungsgemässen Widerstandsnetzwerks justiert werden.

Ausserdem können weitere Widerstandsnetzwerke jeweils mit unterschiedlichen oder gleichen Gesamt-Widerstandswerten R zu jedem der einzelnen Messsensoren in Serie oder parallel dazu geschaltet werden (strich-punktiert gezeichnet). Somit können sowohl die einzelnen Messsensoren als auch die gesamte Brückenschaltung durch die erfindungsgemässen Widerstandsnetzwerke justiert werden.

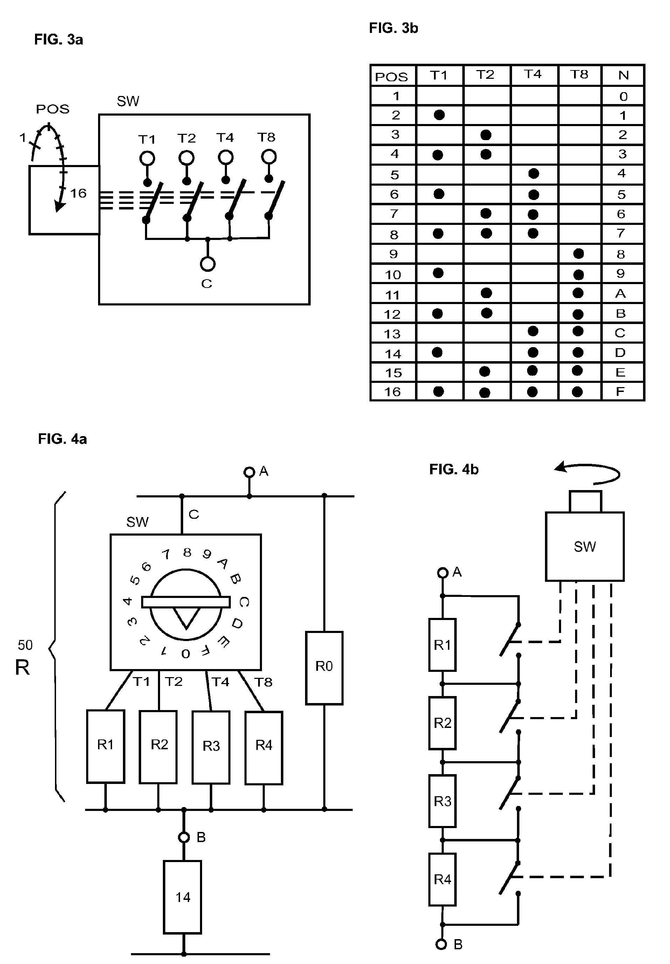

Figuren 3a und 3b zeigen eine vereinfachte schematische Darstellung eines binär codierenden Schaltelements SW in Form eines Drehschalters. Ein solcher Drehschalter könnte zum Beispiel der codierende Drehschalter der Firma ELMA ELECTRONIC vom Typ 1848.1235 sein. Es können aber auch andere codierende Schaltelemente, insbesondere lineare Codierer, ein BCD-Codierer oder ein linear verstellbares Schaltelement, verwendet werden.

Figur 3a zeigt eine vereinfachte schematische Darstellung des codierenden Drehschalters SW mit einem Bedienkopf zum Einstellen der Schaltstellung POS, einem gemeinsamen Anschlusspunkt C und vier binär beschalteten Schaltkontakten T1, T2, T4 und T8. Je nach Schaltstellung POS sind die Schaltkontakten T1, T2, T4 und T8 jeweils mit dem gemeinsamen Anschlusspunkt C elektrisch verbunden oder von diesem getrennt. Diese Steuerung ist durch die gestrichelten Linien angedeutet und wird im nächsten Abschnitt genauer beschrieben. Durch eine Drehung am Bedienknopf können schrittweise 16 verschiedene Schaltstellungen POS eingestellt werden, welche durch die Positionen "1" bis "16" bezeichnet sind. Grundsätzlich können die Schaltstellungen des Schaltelements oder des Drehknopfs mit beliebigen Symbolen, Ziffern, Farben und/oder Buchstaben bezeichnet werden. Vorzugsweise werden jedoch Zahlenwerte in hexadezimaler Darstellung gewählt.

Figur 3b zeigt eine beispielhafte Schalttabelle für das Schaltelement SW gemäss Figur 3a zur Definition der Beschaltung der Schaltkontakte pro Schaltstellung POS und einen zugehörigen Zahlenwert N. Dabei bedeutet ein schwarzer Punkt, dass eine elektrische Verbindung zwischen dem jeweiligen Schaltkontakt T1, T2, T4 und T8 und dem gemeinsamen Anschlusspunkt C besteht. Bei einem weissen Feld hingegen, ist eine solche Verbindung unterbrochen. Beispielsweise ist bei der Schaltstellung POS mit hexadezimalem Wert "9" der Schaltkontakt T1 und T8 mit dem Anschlusspunkt C verbunden, während die Schaltkontakt T2 und T4 davon getrennt sind.

Die verbundenen Schaltkontakte können durch eine "1" und ein getrennten Schaltkontakt durch eine "0" repräsentiert werden. Ausserdem kann dem ersten Schaltkontakt T1 die niedrigstwertige Stelle des Zahlenwerts N, dem zweiten Schaltkontakt T2 die nächst niedrigstwertige Stelle, dem dritten Schaltkontakt T4 die übernächst niedrigstwertige Stelle und dem vierten Schaltkontakt T8 die höchstwertige Stelle des Zahlenwerts N zugeordnet werden. Gemäss dieser Repräsentation der Beschaltung ergibt sich dann der Zahlenwert N, der in dualer Darstellung von "0000" bis "1111" läuft und die 16 möglichen Schaltstellungen POS des Drehschalters SW eindeutig bezeichnet. Zweckmässigerweise werden meistens die 16 verschiedenen Zahlenwerte in hexadezimaler Weise dargestellt, nämlich als Werte "0" bis "F" und zur Bezeichnung der Schaltstellungen des Drehknopfs verwendet.

Wie aus der Schalttabelle ersichtlich sind die Schaltkontakte T1, T2, T4 und T8 derart beschaltet, dass eine fortschreitende Veränderung der Schaltstellung POS von "1" auf "16" eine fortschreitende Erhöhung des Zahlenwerts N bewirkt, nämlich eine fortschreitende Erhöhung des Zahlenwerts von "0000" bis "1111" in binärer oder von "0" bis "15" in dezimaler Darstellung. Dadurch ist jeder der möglichen Schaltstellungen POS des Schaltelements SW eine eindeutige Verdrahtung der Schaltkontakte T1, T2, T4 und T8 zugeordnt ist und ausserdem ist das Verhältnis zwischen der Anzahl der möglichen Schaltstellungen POS und der Anzahl der Schaltkontakte T1, T2, T4 und T8 maximal.

Figuren 4a und 4b zeigen jeweils vereinfachte Blockschemata des erfindungsgemäss veränderbaren Widerstandsnetzwerks 50 mit dem codierenden Schaltelement SW gemäss Figur 3.

Figur 4a zeigt ein vereinfachtes Blockschema des erfindungsgemäss veränderbaren Widerstandsnetzwerks 50 gemäss Figur 2 mit dem codierenden Schaltelement SW gemäss Figuren 3a und 3b. Dabei umfasst das Widerstandsnetzwerk 50 das Schaltelement SW, und vier Teilwiderstande R1, R2, R3 und R4, welche durch das Schaltelement SW parallel schaltbar sind, sowie einen Shunt-Widerstand R0. Durch das Zusammenwirken dieser Widerstände ergibt sich der Gesamt-Widerstandswert R des Widerstandsnetzwerks 50. Das Widerstandsnetzwerk 50 ist, wie in Figur 2 dargestellt, einerseits über seinen ersten Anschluss A mit der ersten Signalleitung und andererseits über den zweiten Anschluss B mit einem Eckpunkt der Brückenschaltung verbunden. Dabei wird Brückenschaltung vereinfachend durch den Messsensor 14 repräsentiert.

Das Schaltelement SW weist vier Schaltkontakte T1, T2, T4 und T8 auf, wobei die 16 Schaltstellungen POS durch Zahlenwerte in hexadezimaler Darstellung bezeichnet sind. Der gemeinsame Anschlusspunkt C des Drehschalters SW ist mit dem ersten Anschluss A des Widerstandsnetzwerks 50 verbunden. Ausserdem sind die Schaltkontakte T1, T2, T4 und T8 des Drehschalters SW jeweils über die Teilwiderstände R1, R2, R3 und R4 mit dem zweiten Anschluss B des Widerstandsnetzwerks 50 verbunden. Ferner ist der Shunt-Widerstand R0 zwischen dem Anschluss A und dem Anschluss B parallel dazu geschaltet, um einen bestimmten Maximalwert des Gesamt-Widerstandswert R vorgeben zu können.

Erfindungsgemäss kann nun durch einfache Drehung des Drehschalters SW der Gesamt-Widerstandswert R des Widerstandsnetzwerks 50 zwischen dem Wert R0 bei Position "0" und dem Wert 0 bei Position "F" in 16 Stufen reduziert werden. Selbstverständlich können eine Vielzahl von Varianten Widerstandsnetzwerks 50 realisiert werden, beispielsweise durch Serieschaltungen und/oder Parallelschaltungen von weiteren Teilwiderständen oder durch eine Serieschaltung des Drehschalters SW mit weiteren einzelnen Teilwiderständen.

Figur 4b zeigt ein vereinfachtes Blockschema des erfindungsgemäss veränderbaren Widerstandsnetzwerks 50 gemäss Figur 4a, jedoch mit in Serie schaltbaren Teilwiderständen R1, R2, R3 und R4 und ohne den Shunt-Widerstand R0. Je nach Schaltstellung POS des Drehschalters SW wird einer oder werden mehrere der Teilwiderstände R1, R2, R3 und R4 kurzgeschlossen. Somit kann der Gesamt-Widerstandswert R des Widerstandsnetzwerks 50 zwischen dem Wert 0 und der Gesamtsumme R1+R2+R3+R4 der Widerstandswerte der einzelnen Teilwiderstände R1, R2, R3 und R4 durch einfaches Drehen des Drehschalters SW variiert werden.

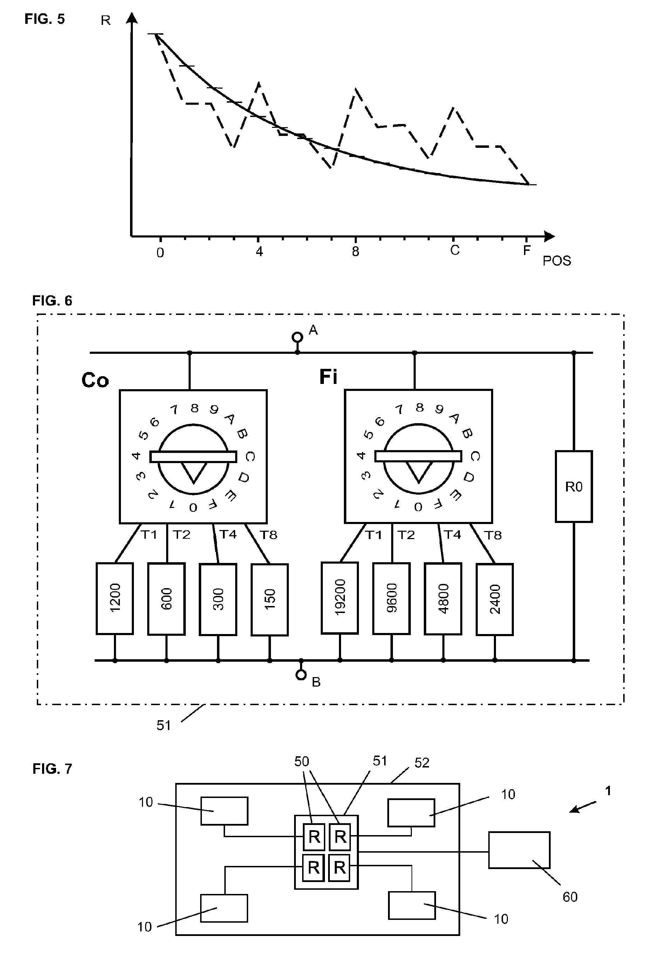

Figur 5 zeigt zwei vereinfachte Verläufe des Gesamt-Widerstandswerts R des Widerstandsnetzwerks 50 in Abhängigkeit der Schaltstellung POS. Dabei weisen in einem ersten Fall, der als gestrichelte Linie dargestellt ist, alle Teilwiderstände R1, R2, R3 und R4 ähnliche Widerstandswerte auf, zum Beispiel 3300 Ohm. In einem zweiten Fall, der als durchgezogene Linie dargestellt ist, sind die Widerstandswerte entsprechend der Codierung des Schaltelements SW dimensioniert. In diesem Beispiel mit einem binär codierenden Schaltelement SW sind die Teilwiderstände R1, R2, R3 und R4 binär abgestuft und weisen folgende Widerstandswerte auf: R1 = 1200 Ohm, R2 = 600 Ohm, R3 = 300 Ohm, R4 = 150 Ohm.

Bei gleich dimensionierten Teilwiderständen entstehen durch eine binäre Codierung Rücksprünge im Verlauf des Gesamt-Widerstandswerts R bei einer fortschreitenden Änderung der Schaltstellung POS. Beispielsweise führt ein ein-schrittiger Übergang der Schaltstellung POS von "0111" auf "1000" (in dualer Darstellung der Zahlen) von einer Parallelschaltung der drei Teilwiderstände R1, R2 und R3 zu einer Durchgangsschaltung eines einzelnen Teilwiderstands R4. Dadurch ergibt sich ein höherer Gesamt-Widerstandswert R. Typischerweise führt jedoch ein höherer Zahlenwert N zu einer gleichen oder höheren Anzahl von Parallelschaltungen und damit zu einem tieferem Gesamt-Widerstandswert R.

Hingegen ergibt sich bei einer bevorzugter Dimensionierung der Teilwiderstände R1, R2, R3 und R4 eine monoton abfallende Funktion des Widerstandswerts R in Abhängigkeit zur fortschreitenden Schaltstellung POS. Die codierende Wirkung des Schaltelements SW wird durch die Codierung der Widerstandswerte R1, R2, R3 und R4 praktisch aufgehoben, sodass sich ein stetiger Verlauf ohne Rücksprünge ergibt. Somit kann die Justierung der Kraftmessvorrichtung 1 auf besonders einfache und intuitive Weise durchgeführt werden, ohne das Hilfsmittel wie Codiertabellen oder Rechner herangezogen werden müssen.

Figur 6 zeigt ein weiteres Ausführungsbeispiel der Erfindung mit einem ersten und zweiten Widerstandsnetzwerk 50 gemäss Figur 4, welche im Wesentlichen parallel geschaltet sind. Das erste Widerstandsnetzwerk 50, deren Teilwiderstände R1, R2, R3 und R4 die Widerstandswerte 1200 Ohm, 600 Ohm, 300 Ohm und 150 Ohm aufweisen, dient zur Grobjustierung Co des Widerstandswerts R. Das zweite Widerstandsnetzwerk 50 mit den Widerstandswerten 19200 Ohm, 9600 Ohm, 4800 Ohm und 2400 Ohm dient zur Feinjustierung Fi des Widerstandswerts R. Auch in diesem Fall wird mit dem parallel geschalteten Shunt-Widerstand R0 ein Maximalwert des Gesamt-Widerstandswerts R vorgegeben.

Für die Widerstandswerte können auch kostengünstige Teilwiderstände mit standardmässiger Dimensionierungen verwendet werden, beispielsweise die Widerstandswerte 8.06 kOhm, 4.02 kOhm, 2 kOhm und 1 kOhm zur Grobjustierung Co und die Widerstandswerte 128 kOhm, 64.9 kOhm, 31.6 kOhm und 16 kOhm zur Feinjustierung Fi, wobei der Shunt-Widerstand R0 den Widerstandswert 600 Ohm aufweist.

Ausserdem können die beiden Widerstandsnetzwerke 50 in einer Verschaltungsbox 51 zusammengefasst werden (gestrichelt gezeichnet), welche derart ausgebildet ist, dass eine Betätigung des mindestens einen Schaltelements SW von ausserhalb der Verschaltungsbox 51 möglich ist. Vorzugsweise ist die Verschaltungsbox 51 verschliessbar oder versiegelbar.

Figur 7 zeigt eine stark vereinfachte schematische Darstellung einer Bodenwaage 1 mit vier Kraftmesszellen 10. Diese vier Kraftmesszellen 10 sind zwischen einer sogenannten Messplatte 52 und einem Boden oder einer Bodenplatte angeordnet. Dabei wirkt die Messplatte als Kraftaufnahme oder Waagschale, indem die Messplatte die zu messende Kraft aufnimmt und an die vier Kraftmesszellen 10 weiterleitet. Durch die Messplatte 52 sind die vier Kraftmesszellen 10 derart gekoppelt, dass diesen jeweils ein Teil der zu messenden Kraft zugeführt wird.

Jede der vier Kraftmesszellen 10 ist mit einem erfindungsgemässen Widerstandsnetzwerk 50 verbunden, sodass jeder einzelne der Kraftmesszellen 10 durch Veränderung des entsprechenden Gesamt-Widerstandswerts R justierbar ist.

Die vier Widerstandsnetzwerk 50 sind in einer Verschaltungsbox 51 angeordnet. Dadurch kann die Verschaltungsbox 51 im Servicefall auf einfache Weise ausgetauscht werden. Die Verschaltungsbox 51 beziehungsweise die darin enthaltenen Widerstandsnetzwerke 50 sind mit einem Terminal oder einer Signalverarbeitungseinheit 60 verbunden.

Selbstverständlich können die erfindungsgemässen Widerstandsnetzwerke 50 bei beliebigen Mehrfach-Kraftmessvorrichtungen eingesetzt werden. Beispielsweise bei Balkenwagen mit zwei Kraftmesszellen 10 oder bei Wägebrücken für Lastwagen mit 8, 12, oder 16 Kraftmesszellen.

Das erfindungsgemässe Widerstandsnetzwerk 50 und die Kraftmessvorrichtung 1 wurde in bevorzugten Ausgestaltungen beschrieben und dargestellt. Selbstverständlich sind diese Ausführungen auch auf die andere Brückenschaltung übertragbar. So können beispielsweise verschiedene Widerstandsnetzwerke 50 in jeden Teil einer Brückenschaltung vorhanden sein und mit den jeweiligen Messsensoren 14a, 14b, 14c und 14d zusammengeschaltet werden. Somit stehen in einer solchen Ausführung acht Schaltelemente SW für die Justierung der Waage zur Verfügung, nämlich pro Messsensor 14a, 14b, 14c und 14d je zwei, jeweils einer zur Grobjustierung Co und zur Feinjustierung Fi.

Die Kraftmessvorrichtung wurde in der Ausgestaltung einer Waage 1 beschrieben. Die Erfindung ist jedoch auch bei anderen Kraftmessvorrichtungen, wie gravimetrischen Messgeräten, Wägemodule, Lastzellen und Messsensoren, die gegebenenfalls Teil einer Waage bilden können, einsetzbar. Ferner sind die Vorrichtungen natürlich auch nicht auf eine bestimmte Wahl, Konfiguration, Gruppierung und Anwendung der Komponenten beschränkt.

### Bezugszeichenliste

- 1: Kraftmessvorrichtung
- 10: Kraftmesszelle
- 11: feststehender Teil
- 12: beweglicher Teil
- 13: Mittelteil
- 14, 14a, 14b, 14c, 14d: Messsensor
- 15: Messleitung
- 16: Versorgungsleitung
- 20: Gehäuse
- 21: Support
- 22: Gehäusedurchführung
- 30: Kraftaufnahme
- 31: Gestänge
- 32: Kraftübertragungsarm
- 33: Auflagestelle
- 50a, 50b, 50c, 50d: Widerstandsnetzwerk
- 51: Verschaltungsbox
- 52: Messplatte
- 60: Signalverarbeitungseinheit
- 61: Verbindungsleitung
- 70: Anzeigeeinheit
- A,: B Anschluss
- C: Anschlusspunkt
- Co: Grobjustierung
- Fi: Feinjustierung
- mL, mLx: Kraftmesssignal
- N: Zahlenwert
- POS: Schaltstellung
- R: Gesamt-Widerstandswert
- R0: Shunt-Widerstand
- R1, R2, R3, R4: Teilwiderstand
- T1, T2, T4, T8: Schaltkontakt
- U: Strom-/Spannungsversorgung
- SW: Schaltelement, Drehschalter

## Patentansprüche

1. Widerstandsnetzwerk (50) für eine Kraftmessvorrichtung (1), insbesondere eine Waage, mit mindestens zwei elektrischen Teilwiderständen (R1, R2, R3, R4), welche abgestufte Widerstandwerte aufweisen, sodass jeweils eine unterschiedliche elektrische Verdrahtung der Teilwiderstände (R1, R2, R3, R4) einen unterschiedlichen Gesamt-Widerstandswert (R) des Widerstandsnetzwerks (50) ergibt, **dadurch gekennzeichnet, dass** das Widerstandsnetzwerk (50) zur Verdrahtung der Teilwiderstände (R1, R2, R3, R4) ein codierendes Schaltelement (SW) aufweist, sodass verschiedenen Schaltstellungen (POS) des Schaltelements (SW) verschiedene Verdrahtungen der Teilwiderstände (R1, R2, R3, R4) zuordenbar sind und die Anzahl der Teilwiderstände (R1, R2, R3, R4) geringer ist als die Anzahl der möglichen Schaltstellungen (POS).

2. Widerstandsnetzwerk (50) nach Anspruch 1, **dadurch gekennzeichnet, dass** das Schaltelement (SW) mindestens zwei veränderbar beschaltete Schaltkontakte (T1, T2, T4, T8) aufweist, welche jeweils mit den Teilwiderständen (R1, R2, R3, R4) verbunden sind, um diese gemäss der zugeordneten Schaltstellung (POS), insbesondere in Serie oder parallel, zu beschalten.

3. Widerstandsnetzwerk (50) nach Anspruch 1 oder 2, **dadurch gekennzeichnet, dass** mittels des Schaltelements (SW) jeder der Teilwiderstände (R1, R2, R3, R4) einzeln anwählbar oder mindestens zwei der Teilwiderstände (R1, R2, R3, R4) miteinander parallel und/oder in Serie verschaltbar sind.

4. Widerstandsnetzwerk (50) nach einem der Ansprüche 1 bis 3, **dadurch gekennzeichnet, dass** den Schaltstellungen (POS) ein Zahlenwert (N) zuordenbar ist, indem jedem Teilwiderstand (R1, R2, R3, R4) jeweils eine Stelle des Zahlenwerts (N) zugeordnet werden kann, wobei der Wert dieser Stelle zur Verdrahtung des Teilwiderstands (R1, R2, R3, R4) korrespondiert und dass eine fortschreitende Veränderung der Schaltstellung (POS) eine fortschreitende Veränderung des Zahlenwerts (N) bewirkt.

5. Widerstandsnetzwerk (50) nach einem der Ansprüche 1 bis 4, **dadurch gekennzeichnet, dass** das Schaltelement (SW) derart ausgebildet ist, dass jeder der möglichen Schaltstellungen (POS) des Schaltelements (SW) eine eindeutige Verdrahtung der Teilwiderstände (R1, R2, R3, R4) zuordenbar ist und/oder dass das Verhältnis zwischen der Anzahl der möglichen Schaltstellungen (POS) und der Anzahl der Teilwiderstände (R1, R2, R3, R4) maximal ist.

6. Widerstandsnetzwerk (50) nach einem der Ansprüche 1 bis 5, **dadurch gekennzeichnet, dass** das codierende Schaltelement auf einem Stellenwertsystem, insbesondere einem Dualsystem, einem BCD-System oder einem Hexadezimalsystem, basiert.

7. Widerstandsnetzwerk (50) nach einem der Ansprüche 1 bis 6, **dadurch gekennzeichnet, dass** das Schaltelement (SW) als DIP-Schalter, insbesondere als Rotations-DIP-Schalter, ausgebildet ist.

8. Widerstandsnetzwerk (50) nach einem der Ansprüche 1 bis 7, **dadurch gekennzeichnet, dass** die Teilwiderstände (R1, R2, R3, R4) derart dimensioniert, dass der Gesamt-Widerstandswert (R) des Widerstandsnetzwerks (50) eine von der Schaltstellung (POS) abhängige, weitgehend monoton steigende oder monoton abfallende Funktion ist.

9. Widerstandsnetzwerk (50) nach einem der Ansprüche 1 bis 8, **dadurch gekennzeichnet, dass** die Widerstandswerte der Teilwiderstände (R1, R2, R3, R4) in Wesentlichen einer standardmässigen Dimensionierung entsprechen.

10. Widerstandsnetzwerk (50) nach einem der Ansprüche 1 bis 9, **dadurch gekennzeichnet, dass** dem Widerstandsnetzwerk (50) mindestens ein weiteres Widerstandsnetzwerke (50) nach einem der Ansprüche 1 bis 7, insbesondere parallel oder in Serie, zugeschaltet ist.

11. Widerstandsnetzwerk (50) nach Anspruch 10, **dadurch gekennzeichnet, dass** eines der Widerstandsnetzwerke der Grobjustierung und eines der Widerstandsnetzwerke (50) der Feinjustierung (Fi) dient.

12. Verschaltungsbox (51) mit einem Innenraum, in welchem mindestens ein Widerstandsnetzwerk (50) nach einem der Ansprüche 1 bis 11 angeordnet ist, wobei die Verschaltungsbox (51) verschliessbar, insbesondere versiegelbar, ist.

13. Kraftmessvorrichtung (1), insbesondere eine Waage, mit mindestens einer Kraftmesszelle (10), welche mindestens einen Messsensor (14) aufweist, der mit mindestens einem Widerstandsnetzwerk (50) nach einem der Ansprüche 1 bis 11 derart verbunden ist, dass das Widerstandsnetzwerk (50) in Serie oder parallel zu dem mindestens einen Messsensor (14) geschaltet ist.

14. Kraftmessvorrichtung (1) nach Anspruch 13 mit mindestens zwei, insbesondere vier, gegebenenfalls über eine als Kraftaufnahme wirkende Messplatte (52) gekoppelte, Kraftmesszellen (10), welche jeweils mit dem mindestens einen zugehörigen Widerstandsnetzwerk (50) verbunden sind, sodass Unterschiede zwischen den einzelnen Kraftmesszellen (10) durch eine Justierung ausgleichbar sind.

15. Verfahren zur Justierung einer Kraftmessvorrichtung (1) mit einem Widerstandsnetzwerk (50) nach einem der Ansprüche 1 bis 11, wobei die Justierung durch eine schrittweise Veränderung der Schaltstellung (POS) des Schaltelements (SW) durchgeführt wird.
